# FASCICULE DE BREVET EUROPEEN

(11) **EP 3 972 240 B1**
(45) Date de publication et mention de la délivrance du brevet: **30.07.2025**
(21) Numéro de dépôt: 21196755.9
(22) Date de dépôt: 15.09.2021
(51) Int. Cl.: H04N 25/74, H04N 5/32, G11C 19/28

(54) **DÉTECTEUR MATRICIEL À PLUSIEURS GROUPES DE MODULES DE PILOTAGE ET PROCÉDÉ DE MISE EN OEUVRE DU DÉTECTEUR**
MATRIXDETEKTOR MIT MEHREREN GRUPPEN VON STEUERMODULEN UND AUSFÜHRUNGSVERFAHREN DIESES DETEKTORS
MATRIX DETECTOR WITH SEVERAL GROUPS OF CONTROL MODULES AND METHOD FOR IMPLEMENTING THE DETECTOR

(30) Priorité: 18.09.2020 FR 2009457
(43) Date de publication de la demande: 23.03.2022
(73) Titulaire: Trixell, 38430 Moirans (FR)
(72) Inventeur: SIAUD, Martin, 38430 MOIRANS (FR); MARECAUX, Simon, 38430 MOIRANS (FR); HORDEQUIN, Chantal, 38430 MOIRANS (FR)
(74) Mandataire: Atout PI Laplace

(56) Documents cités:
- EP-A1- 1 781 015
- FR-A1- 3 092 721

## Description

La présente invention concerne un détecteur matriciel et un procédé de mise en œuvre du détecteur. L'invention trouve une utilité dans la réalisation d'images visibles mais n'est pas limitée à ce domaine. On peut par exemple réaliser des cartographies de pression ou de température ou encore des représentations en deux dimensions de potentiels chimiques ou électriques. Ces cartographies ou représentations forment des images de grandeurs physiques. L'invention s'applique notamment à des détecteurs à matrices actives utilisés par exemple à des fins de détection dans des dispositifs d'imagerie par rayonnements ionisants, par exemple par rayons X, telles que des dalles de type **TFT,** selon le sigle désignant la terminologie anglo-saxonne : « Thin Film Transistor » ou transistor en couches minces.

Dans un détecteur matriciel, un pixel représente l'élément sensible élémentaire du détecteur. Chaque pixel convertit un phénomène physique auquel il est soumis en un signal électrique. Les signaux électriques issus des différents pixels sont collectés lors d'une phase de lecture de la matrice puis numérisés de manière à pouvoir être traités et stockés pour former une image. Les pixels sont formés d'une zone sensible au phénomène physique et délivrent par exemple un courant de charges électriques. Le phénomène physique peut être un rayonnement électromagnétique véhiculant un flux de photons et par la suite, l'invention sera expliquée au moyen de ce type de rayonnement et le courant de charge est fonction du flux de photons reçu par la zone sensible. La généralisation à tout détecteur matriciel sera aisée.

Un détecteur d'images matriciel comprend des conducteurs de ligne, chacun reliant les pixels d'une même ligne, et des conducteurs de colonnes, chacun reliant les pixels d'une même colonne. Les conducteurs de colonnes sont connectés à des circuits de conversion généralement disposés sur un bord de la matrice que l'on peut appeler « pied de colonne ».

Chaque pixel comprend généralement un élément photosensible, ou photodétecteur, qui peut par exemple être une photodiode, une photorésistance ou un phototransistor. On trouve des matrices photosensibles de grandes dimensions qui peuvent posséder plusieurs millions de pixels organisés en lignes et en colonnes. Chaque pixel comprend en outre un circuit électronique constitué par exemple d'interrupteurs, capacités, résistances, en aval duquel est placé un actionneur. L'ensemble constitué par l'élément photosensible et le circuit électronique permet de générer des charges électriques et de les collecter. Le circuit électronique permet généralement la réinitialisation de la charge collectée dans chaque pixel après un transfert de charge. Le rôle de l'actionneur est de transférer ou de recopier les charges collectées par le circuit dans un conducteur de colonne. Ce transfert est réalisé lorsque l'actionneur en reçoit l'instruction d'un conducteur de ligne. La sortie de l'actionneur correspond à la sortie du pixel. Les appellations « conducteur de ligne » et « conducteur de colonne » sont purement arbitraires. Il est bien entendu possible d'inverser ces appellations.

Dans ce type de détecteur, un pixel fonctionne selon deux phases : une phase de prise d'image, durant laquelle le circuit électronique du pixel accumule les charges électriques générées par l'élément photosensible, et une phase de lecture, au cours de laquelle les charges collectées sont transférées ou recopiées dans le conducteur de colonne, grâce à l'actionneur.

Lors de la phase de lecture, une instruction de lecture est émise vers tous les actionneurs d'une même ligne de la matrice au moyen d'un conducteur de ligne. Chacun des pixels de cette ligne est lu en transférant son information électrique, charge, tension, courant, fréquence... au conducteur de colonne auquel il est associé.

Pour une trame d'image, les lignes de pixels peuvent être sélectionnées en séquence, l'une après l'autre suivant un sens de balayage des lignes de la matrice, pendant un temps de sélection de ligne correspondant à une fraction de la durée de la trame, permettant l'application sur les pixels de la ligne considérée de signaux appropriés, par exemple des tensions. Ainsi la sélection d'une ligne correspond à l'application pendant un temps de sélection de ligne correspondant, d'un signal de niveau haut commandant l'état passant des dispositifs de commutation de la ligne de pixels correspondante. En dehors du temps de sélection de la ligne, les dispositifs de commutation sont maintenus à un état bloqué via l'application d'un signal de niveau bas approprié. Par exemple, lorsque les dispositifs de commutation sont des transistors, les signaux à appliquer étant alors des tensions, il est habituel de désigner VGon la tension correspondant au niveau haut et partant à l'état passant du transistor de commutation, et VGoff la tension correspondant au niveau bas et à l'état bloqué du transistor de commutation.

La commande des lignes peut être assurée par des circuits de commande comprenant un ou plusieurs registres à décalage en série, chacun des registres à décalage comprenant une pluralité d'étages en cascade, chaque étage étant apte à commuter les niveaux haut et bas du signal appliqué aux actionneurs des pixels d'une ligne correspondante de la matrice, selon le séquencement de la sélection des lignes, par exemple selon un balayage vertical, comme décrit dans la demande de brevet FR 3 092 721 A1. Les circuits de commande peuvent être mis en œuvre dans des circuits intégrés, un même circuit intégré pouvant par exemple comprendre une pluralité de circuits de commande pour une pluralité de lignes de la matrice. Les circuits intégrés peuvent par exemple être extérieurs à la matrice, et se connecter à celle-ci par des moyens filaires, par exemple des nappes flexibles. Les circuits de commande peuvent également être implantés sur la dalle portant les pixels comme décrit dans la demande de brevet WO 2012/152836 A1 déposée au nom de la demanderesse.

Ceci permet de réduire le nombre de signaux appliqués à la dalle et donc la taille et le nombre des connecteurs souples servant à relier la dalle à son environnement électronique. Cette architecture de circuits de commande intégrés apporte une simplification notable de l'architecture du détecteur par la réduction du nombre de composants et la simplification du procédé de fabrication.

Cependant cette architecture impose l'ordre dans lequel les lignes de matrices sont pilotées. Cet ordre est imposé par les raccordements des circuits de commande et des lignes de la matrice. Dans certains cas, il peut être souhaitable de faire varier l'ordre dans lequel les lignes de matrice sont commandées. Plus précisément, Il peut être souhaitable de regrouper plusieurs pixels pour les lire collectivement. Ce regroupement, connu dans la littérature anglo-saxonne sous le nom de « binning », permet d'améliorer le rapport signal sur bruit de chaque élément lu. Un autre intérêt du regroupement de pixels est d'améliorer la sensibilité du détecteur. Le regroupement se fait cependant au détriment de la résolution spatiale.

Dans le cas où l'information issue de chaque pixel est une charge électrique, le regroupement de pixels est réalisable par une redistribution des charges des pixels à regrouper sur une capacité commune par exemple disposée dans le circuit de conversion en pied de colonne. Ceci peut être réalisé dans un détecteur tel que décrit dans la demande de brevet WO 2012/152836 A1 en lisant chaque ligne de pixels successivement. Cependant, dans un tel détecteur le regroupement de pixels de lignes consécutives ne permet pas d'améliorer la vitesse de lecture du détecteur et donc d'augmenter la fréquence des images produites par le détecteur.

L'invention vise à pallier tout ou partie des problèmes cités plus haut en proposant un détecteur dont les circuits de commande permettent soit une lecture séquentielle classique soit le regroupement de pixels appartenant à des lignes successives en augmentant la vitesse de lecture. L'invention trouve un avantage particulier dans un détecteur où les circuits de commande et les pixels sont réalisés sur un même substrat.

A cet effet, l'invention a pour objet un détecteur matriciel comprenant :
- un ensemble de pixels sensibles à un phénomène physique et organisés en matrice selon des lignes et des colonnes de pixels, chaque pixel générant un signal fonction du phénomène physique, les lignes de pixels étant ordonnées physiquement,
- des conducteurs de ligne permettant chacun de piloter les pixels d'une ligne,
- des modules de pilotage chacun associé à un conducteur de ligne (L), les modules de pilotage délivrant des signaux de sélection, chacun à un des conducteurs de ligne, les modules de pilotage étant répartis en plusieurs groupes entrelacés en fonction de l'ordre des lignes de pixels,
dans lequel les modules de pilotage de chaque groupe sont chainés les uns aux autres dans l'ordre physique des lignes associées aux groupes de modules de pilotage considérés, le chainage de chacun des groupes de modules de pilotage étant indépendant du chainage du ou des autres groupes de modules de pilotage.

Avantageusement, le détecteur matriciel comprend en outre un module de génération de plusieurs jetons délivrés chacun à une entrée d'un premier des modules de pilotage de chaque groupe de modules de pilotage, dans chacun des groupes de modules de pilotage, une sortie de chaque module étant raccordée à une entrée du module de rang supérieur, les modules de pilotage étant ordonnés dans chacun de leur groupe dans l'ordre des lignes de pixels au conducteur duquel le module considéré délivre le signal de sélection. Les jetons peuvent être émis simultanément permettant une lecture par groupe de pixels et peuvent être émis de façon alternée permettant une lecture individuelle des pixels.

Avantageusement, les pixels et les modules de pilotage sont réalisés sur un même substrat à partir de transistors en couche mince de type N uniquement ou de type P uniquement.

L'invention a également pour objet un procédé d'utilisation d'un détecteur matriciel selon l'invention, dans lequel des modules de pilotage appartenant à des groupes distincts et raccordés à des conducteurs de ligne consécutifs peuvent recevoir des signaux de commande simultanés de façon à piloter les lignes consécutives simultanément ou des signaux de commande alternés de façon à piloter les lignes consécutives de façon séparées.

L'invention sera mieux comprise et d'autres avantages apparaîtront à la lecture de la description détaillée d'un mode de réalisation donné à titre d'exemple, description illustrée par le dessin joint dans lequel :
la figure 1 représente un exemple de matrice de pixels pouvant être mis en œuvre dans un détecteur selon l'invention ;
la figure 2 représente un exemple de détecteur selon l'invention ;
la figure 3 représente un exemple de réalisation de plusieurs modules de pilotage mis en œuvre dans le détecteur de la figure 2 ;
la figure 4 représente un autre exemple de réalisation de plusieurs modules de pilotage mis en œuvre dans le détecteur de la figure 2 ;
la figure 5 représente un exemple détaillé d'un module de pilotage de la figure 4 ;
la figure 6 représente sous forme de chronogramme, un exemple de fonctionnement d'un détecteur mettant en œuvre des modules de pilotage tels que représentés sur la figure 5 et chainés en un seul groupe ;
la figure 7 représente sous forme de chronogramme, un exemple de fonctionnement d'un détecteur mettant en œuvre des modules de pilotage tels que représentés sur la figure 5 et chainés en deux groupes pour une lecture individuelle des pixels du détecteur ;
la figure 8 représente sous forme de chronogramme, un exemple de fonctionnement d'un détecteur mettant en œuvre des modules de pilotage tels que représentés sur la figure 5 et chainés en deux groupes pour une lecture commune de pixels de deux lignes consécutives.

Par souci de clarté, les mêmes éléments porteront les mêmes repères dans les différentes figures.

La description qui suit est faite en rapport avec un détecteur matriciel comprenant plusieurs circuits électroniques élémentaires appelés pixels comprenant chacun un élément sensible à une grandeur physique. Les circuits électroniques élémentaires sont, dans l'exemple décrit, des pixels sensibles à un rayonnement lumineux. Il est bien entendu que l'invention peut être mise en œuvre pour d'autres détecteurs sensibles à toute forme de grandeur physique permettant par exemple de réaliser une cartographie de pression ou de température.

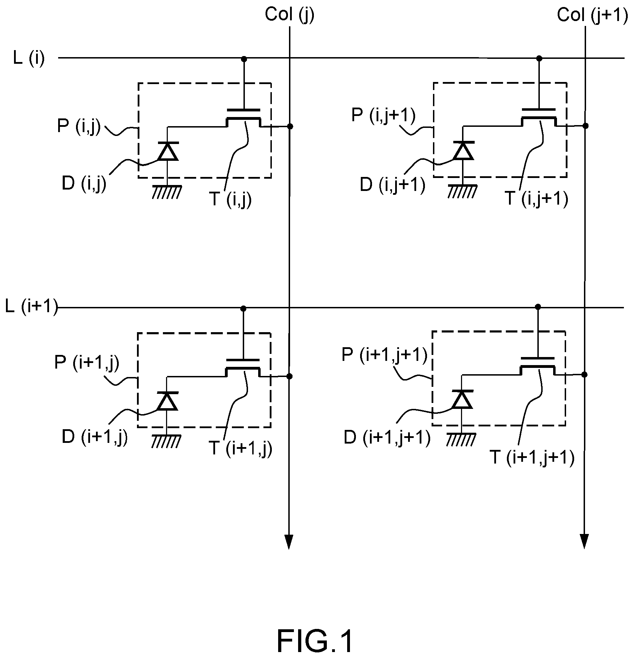

La figure 1 représente schématiquement la zone de détection 10 d'un détecteur matriciel. Cette zone comprend une matrice de deux lignes et deux colonnes pour simplifier la compréhension. Quatre pixels P sont formés, chacun à l'intersection d'une ligne et d'une colonne. Il est bien entendu que les matrices réelles sont généralement beaucoup plus grandes et possèdent un grand nombre de lignes et de colonnes. La matrice de pixels appartient à un détecteur matriciel 12 permettant de réaliser des images numérisées.

Chaque pixel P comprend une zone photosensible, représentée ici par une photodiode D, et un circuit électronique de traitement formé, dans l'exemple de la figure 1, par un seul transistor T. Les références des composants D et T sont suivis de deux coordonnées précisant le rang de la ligne, respectivement i et i+1, et celui de la colonne respectivement j et j+1. Les lignes et les colonnes sont ordonnées dans l'ordre physique qu'elles occupent dans la matrice de pixels. Les pixels représentés sont aussi appelés pixel de type 1T car possédant chacun un transistor dont la fonction va être décrite plus loin.

De façon générale, il est connu de réaliser des matrices de pixels comprenant des transistors à effet de champ à couches minces connus dans la littérature anglo-saxonne sous le nom de TFT pour : « Thin-film transistor ». Les transistors de type TFT peuvent être à base d'oxydes métalliques comme par exemple les transistors à base d'oxyde amorphe ou cristallin d'indium, de gallium et de zinc connus sous leur abréviation anglo-saxonne : IGZO. D'autres familles de transistors de type TFT peuvent être mises en œuvre comme par exemple les TFT organiques, les TFT en silicium amorphe, les TFT en silicium poly cristallin. Dans ce dernier type de transistor TFT, certains ont été synthétisés à basse température. Ils sont connus sous leur abréviation anglo-saxonne : LTPS pour « Low-temperature polycrystalline silicon ».

Les pixels P d'une même colonne sont raccordés à un conducteur de colonne Col. Ce conducteur permet le recueil d'informations provenant des pixels qui lui sont reliés. Les pixels P d'une même ligne sont raccordés à un conducteur de ligne L véhiculant un signal VG permettant de commander la ligne de pixels correspondante.

Lors d'une phase de prise d'image, intervenant après une opération de remise à zéro, l'éclairement reçu par la photodiode D fait décroître le potentiel de sa cathode. Cette phase de prise d'image est suivie d'une phase de lecture pendant laquelle, on lit le potentiel de la photodiode D. Pour ce faire, on rend passant le transistor T, qui a donc un rôle d'interrupteur commandé par le signal de commande VG appliquée à sa grille.

Le conducteur de colonne Col est utilisé pour le recueil d'information provenant d'un pixel de la colonne correspondante lorsque celui-ci est sélectionné au moyen du signal VG.

Il est possible de mettre en œuvre l'invention dans un détecteur dont les pixels sont plus simples, notamment en remplaçant le transistor T par une simple diode mise en conduction au moyen du signal VG. Il est également possible de mettre en œuvre l'invention dans un détecteur dont les pixels comprennent plusieurs transistors. Il est notamment connu de mettre en œuvre des pixels de type 3T comprenant en complément du transistor de lecture décrit plus haut, un transistor de remise à zéro de la photodiode et un transistor suiveur. Dans ce type de pixel 3T, un second conducteur de ligne véhicule un signal de remise à zéro permettant de commander le transistor de remise à zéro.

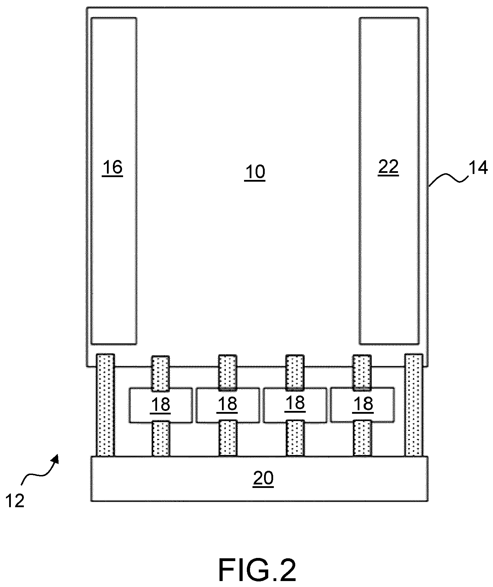

La figure 2 représente schématiquement le détecteur 12 dans son ensemble. Le détecteur 12 comprend une dalle 14 formant le substrat sur lequel sont réalisés les composants de la zone de détection 10. Sur cette même dalle 14 sont disposés des modules de pilotage 16 délivrant des signaux de commande à tous les conducteurs de ligne L. Alternativement les modules de pilotage 16 peuvent être réalisés sur un substrat distinct de la dalle 14. Cependant la réalisation des modules de pilotage 16 sur le même substrat que les pixels P permet de limiter les connexions reliant la dalle 14 à son environnement.

Le détecteur 12 comprend des circuits de lecture 18 reliés aux conducteurs de colonne Col. Les circuits de lecture 18 sont, quant à eux, généralement réalisés sur des substrats distincts de la dalle 14. Les circuits de lecture 18 sont reliés à la dalle 14 au moyen de nappes.

Le détecteur 12 comprend un circuit 20 permettant de piloter les modules de pilotage 16 et permettant de récupérer les signaux issus des circuits de lecture 18, notamment pour les multiplexer.

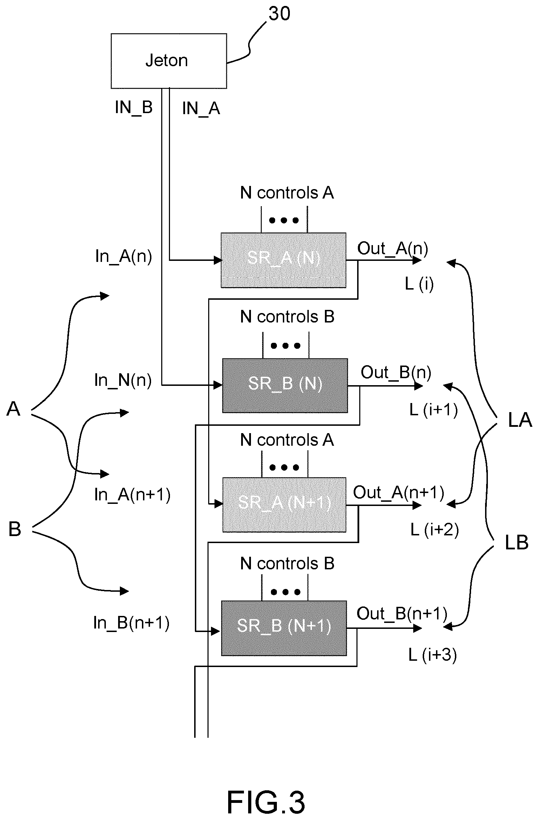

La figure 3 représente un premier exemple de réalisation de quatre modules de pilotage 16 chacun étant configuré pour piloter une ligne de pixels. Il est bien entendu que l'invention peut être mise en œuvre pour un plus grand nombre de lignes de pixels. Plus précisément, la sortie Out_A(n) du premier module de pilotage, noté SR_A(N), est raccordée à un conducteur de ligne L(i) véhiculant un signal VG de lecture de la ligne i. La sortie Out_B(n) du deuxième module de pilotage, noté SR_B(N) est raccordée à un conducteur de ligne L(i+1) véhiculant un signal VG de lecture de la ligne i+1. La sortie Out_A(n+1) du troisième module de pilotage, noté SR_A(N+1) est raccordée à un conducteur de ligne L(i+2) véhiculant un signal VG de lecture de la ligne i+2. La sortie Out_B(n+1) du quatrième module de pilotage, noté SR_B(N+1) est raccordée à un conducteur de ligne L(i+3) véhiculant un signal VG de lecture de la ligne i+3. Les lignes et les modules de pilotage sont ordonnés dans l'ordre de la figure 3. Plus précisément, dans une lecture individuelle de chacune des lignes de pixels, on lit la ligne i, puis la ligne i+1, puis la ligne i+2 et enfin la ligne i+3. Comme on le verra plus loin, les modules de pilotages sont configurés pour permettre également une lecture en regroupant les lignes par paires successives.

Dans l'exemple représenté, les modules de pilotage sont répartis en deux groupes, SR_A(N) et SR_A(N+1) dans un premier groupe A et SR_B(N) et SR_B(N+1) dans un second groupe B. L'invention peut être mise en œuvre avec un nombre plus important de groupes de modules de pilotage. Les lignes sont également regroupées en deux groupes : LA pour les lignes L(i) et L(i+2) d'une part et LB pour les lignes L(i+1) et L(i+3) d'autre part. Le groupe de module de pilotage A est associé aux lignes du groupe LA et le groupe de module de pilotage B est associé aux lignes du groupe LB. Les groupes de lignes LA et LB et donc les groupes de modules de pilotage A et B sont entrelacés. Plus précisément, dans chaque groupe, les modules de pilotage sont ordonnés en suivant l'ordre physique des lignes de la matrice. Pour deux groupes de modules de pilotage A et B, dans l'ordre physique des lignes de la matrice, le premier module de pilotage du premier groupe A : SR_A(1) pilote la première ligne L(1) de la matrice. Le premier module de pilotage du deuxième groupe B : SR_B(1) pilote la deuxième ligne L(2). Le deuxième module de pilotage du premier groupe A : SR_A(2) pilote la troisième ligne L(4). Le deuxième module de pilotage du deuxième groupe B : SR_B(2) pilote la quatrième ligne L(1) et ainsi de suite jusqu'à la dernière ligne de la matrice. Plus généralement, avec K groupes de modules de pilotage, en notant :
i : le rang d'une ligne courante dans l'ordre physique des lignes de la matrice,
j : le rang du module dans son groupe
k : le rang du groupe entre 1 et K

La ligne i est pilotée par le module de rang j du groupe de rang k avec :
i = (j-1)K+k

Le fait de répartir les lignes et les modules de pilotage en différents groupes associés entre eux permet de piloter différemment les groupes de lignes et notamment en adaptant la synchronisation des différents groupes de modules de pilotage et donc en adaptant la synchronisation du pilotage des groupes de lignes.

La figure 3 représente un mode de réalisation permettant de un raccordement particulièrement simple des modules de pilotage. Il est bien entendu que d'autres raccordements sont possibles. Chaque module de pilotage comprend une entrée, respectivement, In_A(n), In_B(n), In_A(n+1), In_B(n+1) permettant de recevoir une commande du module considéré et une sortie permettant de piloter la ligne associée, respectivement, Out_A(n), Out _B(n), Out _A(n+1), Out _B(n+ 1). Dans chaque groupe, les modules de pilotage sont chainés les uns aux autres dans l'ordre des lignes associées aux groupes considérés. Le chainage d'un groupe est indépendant du chainage du ou des autres groupes de modules de pilotage. Plus précisément dans l'exemple représenté, la sortie Out_A(n) est raccordée à l'entrée In_A(n+1) et la sortie Out_B(n) est raccordée à l'entrée In_B(n+1).

Le détecteur 12 comprend un module de génération 30 permettant de générer un premier jeton IN_A délivré à l'entrée du premier module de pilotage SR_A(N) du groupe A. Le module de génération 30 permet également de générer un second jeton IN_B délivré à l'entrée du premier module de pilotage SR_B(N) du groupe B. Le chainage des modules de pilotage permet de faire circuler le jeton d'un module de pilotage au suivant dans un même groupe. De façon plus générale, le module de génération 30 permet de générer autant de jetons que de groupes de modules de pilotage.

Par ailleurs, les modules de pilotage reçoivent un ou plusieurs signaux de contrôle N controls A pour le groupe A et N controls B pour le groupe B. Ces signaux de contrôle sont par exemple des horloges au rythme desquelles les jetons passent d'un module à l'autre dans un même groupe. Les signaux de contrôle peuvent être générés par le module de génération 30 qui peut être disposé sur la dalle 14 ou sur un substrat séparé de la dalle 14, par exemple dans le circuit 20. Les connexions entre les différents modules de pilotage des signaux de contrôle et les connexions des sorties vers les entrées entre modules consécutifs peuvent être réalisées sur la dalle 14 et ne nécessitent donc pas raccordements extérieurs.

Le détecteur 12 peut fonctionner de différentes façons, soit en générant les signaux VG de chaque ligne séquentiellement dans l'ordre des lignes de la matrice, ce qui permet une lecture individuelle des pixels du détecteur 12, soit de façon simultanée dans deux modules de pilotage de même rang dans les deux groupes. Autrement dit, les signaux VG sont émis simultanément par les modules de pilotage SR_A(N) et SR_B(N) puis par les modules de pilotage SR_A(N+1) et SR_B(N+1), ce qui permet le regroupement des informations issues de pixels de lignes différentes. Le choix entre les deux types de lecture du détecteur, soit individuelle soit par groupe de pixels se fait en faisant varier les instants d'émission des jetons IN_A et IN_B et éventuellement des signaux de contrôle des modules de pilotage. Une émission simultanée des deux jetons permet une lecture par groupe. Une émission alternée des deux jetons permet une lecture individuelle.

En répartissant les modules de pilotage en deux groupes, il est possible de regrouper la lecture de deux lignes de pixels. Plus généralement, K groupes permettent de regrouper la lecture de K lignes. Des regroupements de lignes par sous multiples du nombre de groupes est également possible. Par exemple, avec quatre groupes de modules de pilotage, il est possible de lire la matrice, soit individuellement, soit par groupe de deux lignes soit par groupe de quatre lignes en fonction de décalages dans l'émission des jetons des différents groupes et des signaux de contrôle correspondants.

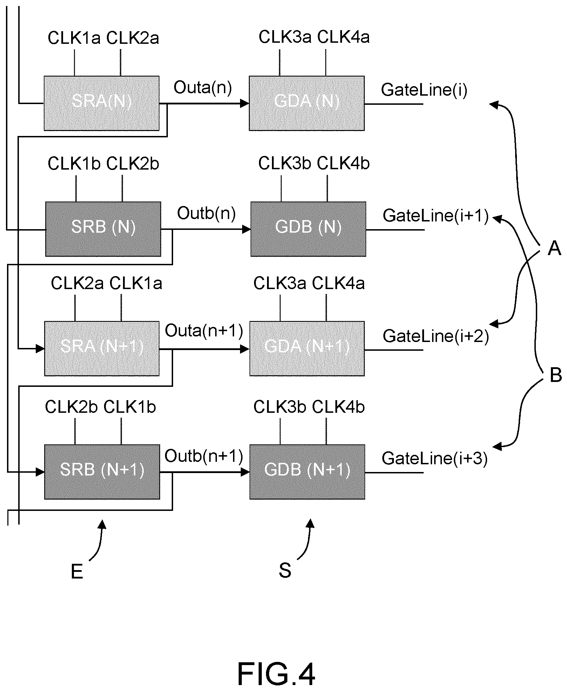

La figure 4 représente un autre exemple de réalisation de quatre modules de pilotage 16 chacun étant configuré pour piloter une ligne de pixels. Dans cet exemple, cheque module de pilotage comprend un étage d'entrée E et un étage de sortie S. L'étage d'entrée E délivre un signal d'activation Outa ou Outb de l'étage de sortie S correspondant. En cas d'activation par l'étage d'entrée, l'étage de sortie correspondant émet le signal de sortie du module de pilotage noté ici Gateline. Cet exemple à deux étages correspond au schéma décrit dans la demande de brevet WO 2012/152836 A1 évoquée plus haut. La transmission du jeton entre deux modules de pilotage successifs d'un même groupe se fait au moyen du signal d'activation transmis à l'entrée de l'étage d'entrée du module de rang supérieur. Les étages d'entrée des différents modules et leur connexion permettant la transmission du jeton forment un registre à décalage. Chaque étage de sortie forme un amplificateur permettant d'adapter le signal d'activation aux caractéristiques du signal VG.

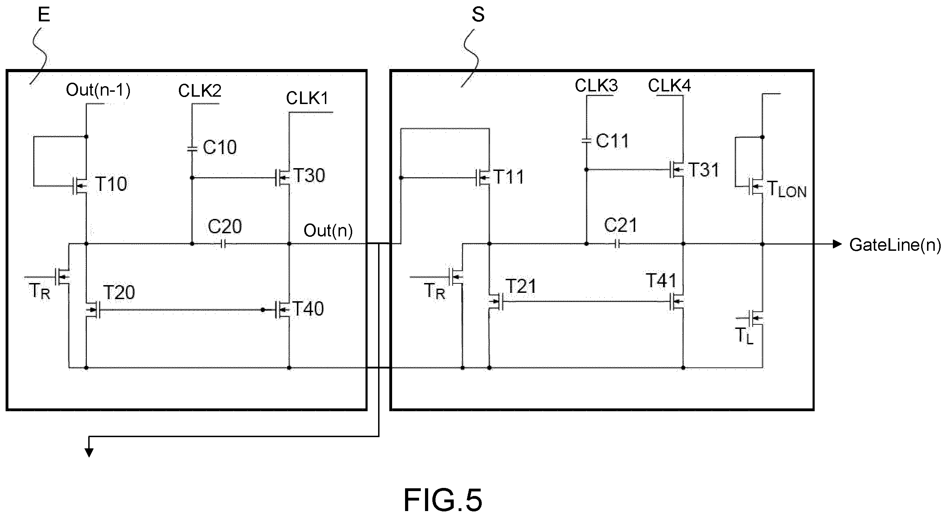

La figure 5 représente plus en détail un schéma d'un des modules de pilotage de la figure 4. La structure intégrée formant un dispositif d'adressage de lignes selon la présente invention peut comprendre essentiellement des transistors **TFT** de type unique, c'est-à-dire de type P ou bien de type N, le type N pouvant être préféré pour ses meilleures performances. Ainsi, tous les transistors décrits par la suite peuvent être à couches minces (TFT) et de type unique N ou P.

La structure illustrée par la figure 5 correspond à un mode de réalisation avantageux dans lequel chaque étage n du dispositif d'adressage de lignes comprend un étage d'entrée 50 et un étage de sortie 51. Pour un étage n du dispositif d'adressage de lignes, chacun des étages d'entrée et de sortie 50, 51 comprend par exemple la plupart des éléments compris dans un étage n d'adressage de lignes tel que décrit précédemment en référence à la figure 3. Il est à noter que dans les exemples de réalisation décrits, chaque ligne n de la matrice est associée à un étage n du dispositif d'adressage. Il est cependant possible, dans des exemples alternatifs non décrits par les figures, d'envisager des structures de dispositifs d'adressage de lignes dans lesquels un étage donné commande une pluralité de lignes, ou bien dans lesquels certaines lignes ne sont pas commandées par un étage.

Ainsi, l'étage d'entrée 50 d'un étage n du dispositif d'adressage de lignes peut être formé par un registre à décalage comprenant une ligne de sortie restituant en sortie un signal d'activation Out(n). L'étage d'entrée 50 peut comprendre un transistor de sortie de l'étage d'entrée T30, transmettant une impulsion d'un signal d'horloge au niveau de la sortie d'activation Out(n). La grille du transistor de sortie de l'étage d'entrée T30 peut être connectée à un nœud interne de l'étage d'entrée du dispositif d'adressage, sa source peut être reliée à la sortie d'activation Out(n) et son drain peut recevoir le signal d'une première horloge CLK1. Un condensateur d'élévation de l'étage d'entrée C20 peut être connecté entre la grille et la source du transistor de sortie de l'étage d'entrée T30. Un premier transistor de commande de l'étage d'entrée T10 est apte à précharger la grille du transistor de sortie de l'étage d'entrée T30. La source du premier transistor de commande de l'étage d'entrée T10 est ainsi connectée à la grille du transistor de sortie de l'étage d'entrée T30. La grille et le drain du premier transistor de commande de l'étage d'entrée T10 sont commandés par la sortie d'activation Out(n-1) de l'étage n-1 du dispositif d'adressage de la ligne précédente n-1.

Un deuxième transistor de commande de l'étage d'entrée T20 est apte à décharger la grille du transistor de sortie de l'étage d'entrée T30. Le drain du deuxième transistor de commande de l'étage d'entrée T20 est ainsi connecté à la grille du transistor de sortie de l'étage d'entrée T30. Un condensateur de compensation de l'étage d'entrée C10 peut avantageusement être disposé entre le signal d'une seconde horloge CLK2, en opposition de phase du signal de la première horloge CLK1.

Avantageusement, un transistor de décharge de l'étage d'entrée T40 peut être connecté à la sortie d'activation Out(n) de l'étage d'entrée 50 de l'étage n du dispositif d'adressage de lignes. La grille du transistor de décharge de l'étage d'entrée T40 est reliée à la grille du deuxième transistor de commande de l'étage d'entrée T20 ; elle est également reliée au signal de sortie d'activation Out(n+1) de l'étage suivant n+1.

D'une manière similaire, l'étage de sortie 51 d'un étage n du dispositif d'adressage de lignes peut être formé par un registre à décalage comprenant une ligne de sortie restituant en sortie un signal Sn. L'étage de sortie 51 peut comprendre un transistor de sortie de l'étage de sortie T31, transmettant une impulsion d'un signal d'horloge au niveau de la sortie Sn. La grille du transistor de sortie de l'étage de sortie T31 peut être connectée à un nœud interne de l'étage de sortie du dispositif d'adressage, sa source peut être reliée à la sortie Sn et son drain peut recevoir le signal d'une troisième horloge CLK3. Un condensateur d'élévation de l'étage de sortie C21 peut être connecté entre la grille et la source du transistor de sortie de l'étage de sortie T31. Un premier transistor de commande de l'étage de sortie T11 est apte à précharger la grille du transistor de sortie de l'étage de sortie T31. La source du premier transistor de commande de l'étage de sortie T11 est ainsi connectée à la grille du transistor de sortie de l'étage de sortie T31. La grille et le drain du premier transistor de commande de l'étage de sortie T11 sont commandés par la sortie d'activation Out(n) de l'étage d'entrée 50 de l'étage n du dispositif d'adressage.

Un deuxième transistor de commande de l'étage de sortie T21 est apte à décharger la grille du transistor de sortie de l'étage de sortie T31. Le drain du deuxième transistor de commande de l'étage de sortie T21 est ainsi connecté à la grille du transistor de sortie de l'étage de sortie T31. Un condensateur de compensation de l'étage de sortie C11 peut avantageusement être disposé entre le signal d'une quatrième horloge CLK4, en opposition de phase du signal de la troisième horloge CLK3. Une particularité des troisième et quatrième horloges CLK3, CLK4 est que leurs rapports cycliques peuvent être différents, et que la somme de leurs périodes respectives à leur niveau haut correspond à la période des première et deuxième horloges CLK1, CLK2.

Avantageusement, un transistor de décharge de l'étage de sortie T41 peut être connecté à la sortie Sn de l'étage de sortie 51 de l'étage n du dispositif d'adressage de lignes, délivrant le signal d'activation de la ligne n. La grille du transistor de décharge de l'étage de sortie T41 est reliée à la grille du deuxième transistor de commande de l'étage de sortie T21 ; elle est également reliée à la sortie d'activation Out(n+1) de l'étage suivant n+1.

Selon une autre spécificité de la présente invention, l'étage d'entrée 50 comprend également un transistor de réinitialisation de l'étage d'entrée TR dont la grille est commandée par une impulsion d'un signal de réinitialisation. La source du transistor de réinitialisation de l'étage d'entrée TR peut être connectée aux sources du deuxième transistor de commande de l'étage d'entrée T20. Le drain du transistor de réinitialisation de l'étage d'entrée TR peut être connecté au drain du deuxième transistor de commande de l'étage d'entrée T20.

De la même manière, l'étage de sortie 51 comprend également un transistor de réinitialisation de l'étage de sortie TR dont la grille est, ainsi que la grille du transistor de réinitialisation de l'étage d'entrée, commandée par une impulsion du signal de réinitialisation. La source du transistor de réinitialisation de l'étage de sortie TR peut être connectée aux sources respectivement du deuxième transistor de commande de l'étage de sortie T21 et du transistor de décharge de l'étage de sortie T41, ainsi qu'aux sources respectivement du deuxième transistor de commande de l'étage d'entrée T20 et du transistor de décharge de l'étage d'entrée T40. Le drain du transistor de réinitialisation de l'étage de sortie TR peut être connecté au drain du deuxième transistor de commande de l'étage de sortie T21.

Ainsi, une impulsion de réinitialisation permet de d'imposer aux différents transistors compris dans les étages d'entrée 50 et de sortie 51, leur état bloqué.

De plus, l'étage de sortie 51 peut comprendre un transistor de réinitialisation de ligne TL. Le transistor de réinitialisation de ligne TL est commandé via sa grille par un signal spécifique. Le drain du transistor de réinitialisation de ligne TL est connecté à la source du transistor de sortie de l'étage de sortie T31. La source du transistor de réinitialisation de ligne TL peut être connectée aux sources des transistors T20, T40, T21 et T41. Le transistor de réinitialisation de ligne TL d'un étage n permet de forcer la tension sur la ligne n à l'état bas. Le transistor de réinitialisation de ligne TL permet de contrôler la tension sur les lignes, c'est-à-dire aux sorties des étages de sortie des étages, et d'y appliquer une tension basse impédance, notamment pendant des "temps morts". En effet, d'une manière typique, le pilotage des détecteurs à rayons X, par exemple, comprend une phase de réinitialisation, suivie d'une phase d'application des rayonnements X ou "fenêtre X", puis d'une phase de lecture. Pendant la fenêtre X, les rayons X se transforment en électrons dans les photodiodes ; la durée de la fenêtre X est relativement longue, typiquement jusqu'à 3,2 secondes, ainsi le transistor de réinitialisation de ligne TL permet d'éviter toute dérive de la matrice.

Avantageusement encore, chaque étage de sortie 51 peut comprendre un commutateur de réinitialisation de matrice, par exemple formé par un transistor de réinitialisation de matrice TLON permettant de réaliser une réinitialisation complète de la matrice. Le transistor de réinitialisation de matrice TLON peut être commandé par un signal de réinitialisation de matrice appliqué à sa grille et à son drain. La source du transistor de réinitialisation de matrice TLON peut être connectée à la source du transistor de sortie de l'étage de sortie T31. Le signal de réinitialisation de matrice commandant le transistor de réinitialisation de matrice TLON peut être la tension VGoff ou la tension d'activation VGon. Lorsque le transistor de réinitialisation de matrice TLON est actif, c'est-à-dire lorsque la tension d'activation VGon est appliquée, la tension d'activation est alors appliquée à l'ensemble de la matrice.

En pratique, une réinitialisation complète de la matrice peut être réalisée suivant la séquence définie par une activation des transistors de réinitialisation de matrice TLON pendant une durée suffisante, suivie d'une activation des transistors de réinitialisation de lignes TL permettant de remettre les lignes à la tension VGoff.

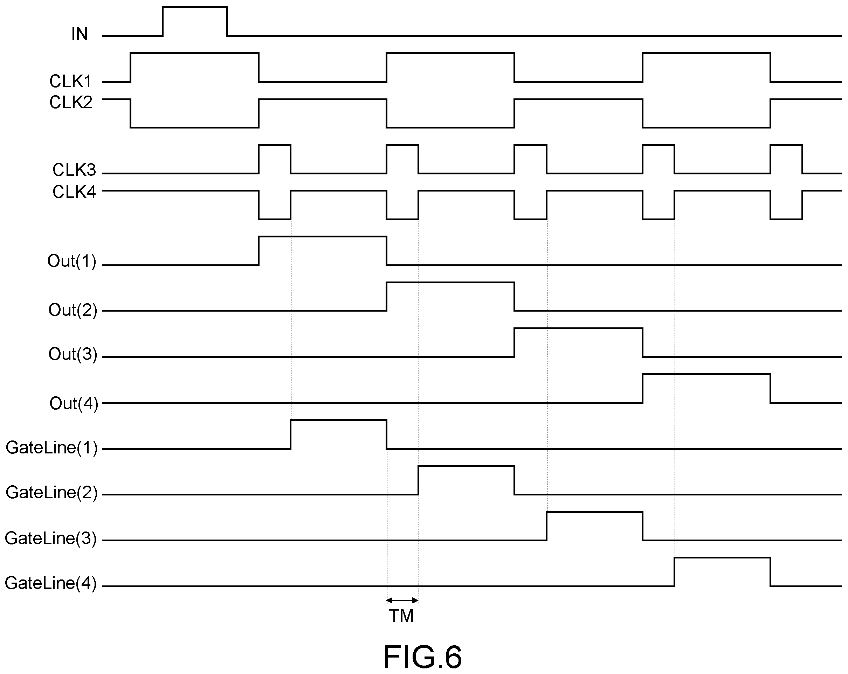

La figure 6 illustre sous forme de chronogramme le fonctionnement de modules de pilotage de la figure 5 disposés en un groupe unique, comme décrit dans la demande de brevet WO 2012/152836 A1. Un jeton unique IN est émis vers la grille et le drain du transistor de commande T10 de l'étage d'entrée E du premier module de pilotage. Les horloges CLK1 et CLK2 sont en opposition de phase, avec une part égale des niveaux haut et bas. Les horloges CLK3 et CLK4 sont également en opposition de phase avec une durée de cycle deux fois plus faible que la durée de cycle des horloges CLK1 et CLK2. La durée du niveau haut de l'horloge CLK4 est plus longue que celle de l'horloge CLK3.

Sur la figure 6, est également représenté le signal Out(n) pour quatre lignes consécutives. Chaque signal Out(n) est décalé d'un demi-cycle de l'horloge CLK1 par rapport au précédent. Le signal Gateline(n) est aussi représenté pour les mêmes quatre lignes. On constate un temps mort TM entre deux niveaux haut de deux signaux Gateline consécutifs. Ce temps mort correspond à la durée du niveau haut de de l'horloge CLK3. Une durée minimum du niveau haut de l'horloge CLK3 est nécessaire afin d'assurer la charge de la grille du transistor T31. En chainant directement les modules de pilotage dans un seul groupe, il est impossible de supprimer ce temps mort.

Au contraire, en répartissant les modules de pilotage en plusieurs groupes, pour une lecture individuelle des pixels, il est possible de masquer le temps mort entre deux modules consécutifs d'un même groupe par le niveau haut d'un signal Gateline d'un autre groupe.

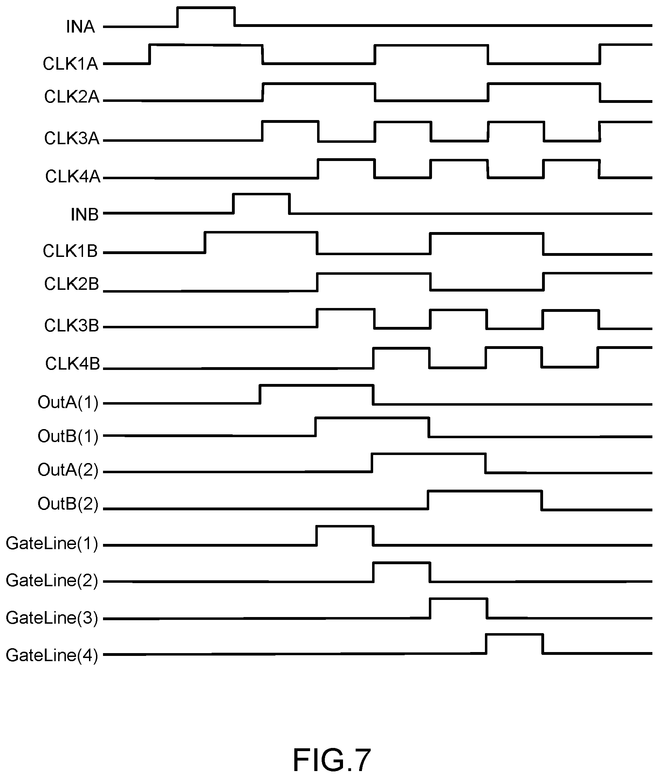

La figure 7 illustre sous forme de chronogramme, un exemple de fonctionnement du détecteur 12 mettant en œuvre des modules de pilotage tels que représentés sur la figure 5 et chainés en deux groupes pour une lecture individuelle des pixels du détecteur. Pour le premier groupe A, on retrouve le jeton INA et les quatre horloges CLK1A, CLK2A, CLK3A et CLK4A. Les horloges CLK1A, CLK2A sont en opposition de phase. Les horloges CLK3A et CLK4A sont également en opposition de phase avec une durée de cycle deux fois plus faible que la durée de cycle des horloges CLK1 et CLK2. Contrairement aux horloges décrites avec la figure 6, les quatre horloges CLK1A, CLK2A, CLK3A et CLK4A possèdent une part égale de leur niveau haut et bas respectif.

Sur la figure 7, sont également représentés pour le groupe B, le jeton INB et les quatre horloges CLK1B, CLK2B, CLK3B et CLK4B. Par rapport au groupe A, les signaux du groupe B sont décalés d'un quart de cycle d'horloge CLK1A.

Pour le groupe A, deux signaux OutA(1) et OutA(2) et deux signaux Gateline(1) et Gateline(3) correspondent à deux modules de pilotage consécutifs du groupe A. Les signaux Gateline(1) et Gateline(3) permettent de piloter les lignes de rang 1 et 3 de la matrice. De même pour le groupe B, deux signaux OutB(1) et OutB(2) et deux signaux Gateline(2) et Gateline(4) correspondent à deux modules de pilotage consécutifs du groupe B. Les signaux Gateline(2) et Gateline(4) permettent de piloter les lignes de rang 2 et 4 de la matrice. Autrement dit, les modules de pilotage du groupe A génèrent les signaux Gateline des lignes impaires et les modules de pilotage du groupe B génèrent les signaux Gateline des lignes paires de la matrice.

L'entrelacement des deux groupes permet d'allonger la durée du niveau haut de l'horloge CLK3A. Il est ainsi possible de s'assurer de la charge de la grille du transistor T31 sans temps mort entre deux lignes consécutives. En effet, la charge de la grille du transistor T31 d'un module de pilotage du groupe A intervient durant le niveau haut d'un signal Gateline du groupe B.

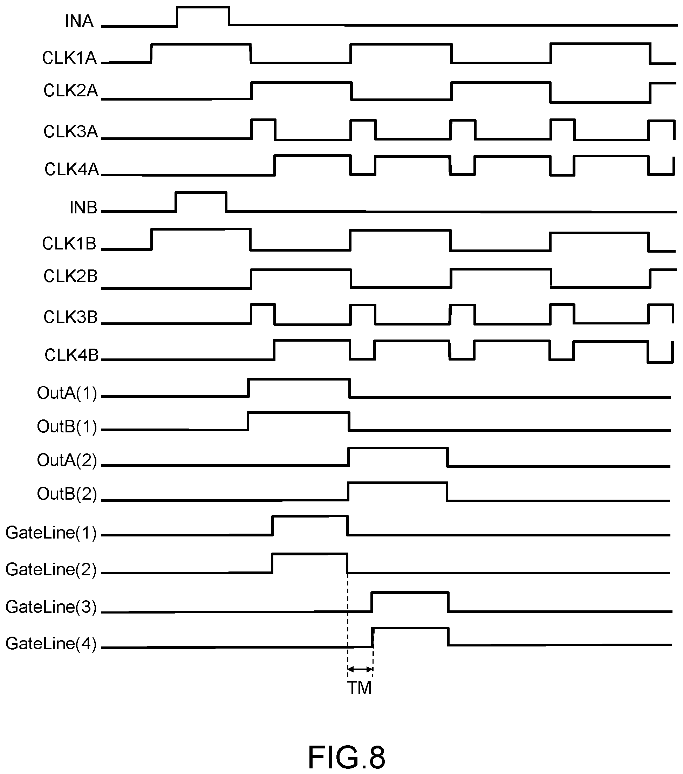

La figure 8 illustre sous forme de chronogramme, un autre exemple de fonctionnement du détecteur 12 mettant en œuvre les modules de pilotage de la figure 5, toujours chainés en deux groupes et cette fois pour une lecture groupée de pixels de lignes consécutives. Autrement dit une ligne paire et une ligne impaire consécutives sont lues simultanément. Dans le fonctionnement décrit à l'aide de la figure 8, le jeton INA est émis simultanément avec le jeton INB. De même les horloges CLK1A, CLK2A, CLK3A et CLK4A sont émises simultanément avec les horloges correspondantes CLK1B, CLK2B, CLK3B et CLK4B. Il s'en suit que les signaux OutA(1) et OutA(2), OutA(3) et OutA(4) Gateline(1) et Gateline(2), Gateline(3) et Gateline(4) sont simultanés.

Le fonctionnement de la figure 8 s'apparente au fonctionnement de la figure 6 aven un temps mort TM entre les signaux Gateline(2) et Gateline(3). Pour limiter la durée de ce temps mort, la durée du niveau haut des horloges CLK3A et CLK3B est inférieure à la durée du niveau bas de ces mêmes horloges.

Le détecteur 12, équipé de plusieurs groupes de modules de pilotage chainés entre eux, permet de choisir différents modes de fonctionnement en fonction du besoin, notamment une lecture individuelle des pixels de la matrice en donnant la possibilité de supprimer tout temps mort entre deux lectures de deux lignes consécutives de la matrice. Le détecteur 12 permet aussi de regrouper les signaux issus de plusieurs pixels pour les lire collectivement.

Les deux exemples de fonctionnement sont donnés pour la lecture de la matrice de pixels P. Dans le schéma de la figure 1, les conducteurs de lignes L sont utilisés pour piloter l'ouverture d'un transistor T (i,j). Ce transistor est utilisé à la fois pour la lecture et pour la remise à zéro de chaque pixel P (i,j) Il est possible de piloter de la même façon ou différemment les pixels pour la lecture et pour la remise à zéro, par exemple, lecture individuelle et remise à zéro collective.

## Revendications

1. Détecteur matriciel comprenant :
- un ensemble (10) de pixels (P) sensibles à un phénomène physique et organisés en matrice selon des lignes et des colonnes de pixels, chaque pixel (P) générant un signal fonction du phénomène physique, les lignes de pixels étant ordonnées physiquement,
- des conducteurs de ligne (L) permettant chacun de piloter les pixels (P) d'une ligne,
- des modules de pilotage (SR_A, SR_B), chacun associé à un conducteur de ligne (L), les modules de pilotage délivrant des signaux de sélection (Out_A, Out_B ; Gateline) chacun à un des conducteurs de ligne (L), les modules de pilotage étant répartis en plusieurs groupes entrelacés en fonction de l'ordre des lignes de pixels,
dans lequel les modules de pilotage (SR_A, SR_B) de chaque groupe (A, B) sont chainés les uns aux autres dans l'ordre physique des lignes associées aux groupes de modules de pilotage considérés, le chainage de chacun des groupes de modules de pilotage étant indépendant du chainage du ou des autres groupes de modules de pilotage,
- un module de génération (30) de plusieurs jetons (INA, INB) délivré chacun à une entrée (In_A(N), In_B(N)) d'un premier des modules de pilotage (SR_A(N)) de chaque groupe (A, B) de modules de pilotage, dans chacun des groupes de modules de pilotage, une sortie (Out_A(n), Out_B(n)) de chaque module étant raccordée à une entrée (In_A(n+1), In_B(n+1)) du module de rang supérieur, les modules de pilotage étant ordonnés dans chacun de leur groupe (A, B) dans l'ordre des lignes de pixels au conducteur duquel le module de pilotage considéré délivre le signal de sélection, les jetons (INA, INB) pouvant être émis simultanément permettant une lecture par groupe de pixels (P) et pouvant être émis de façon alternée permettant une lecture individuelle des pixels (P).

2. Détecteur matriciel selon la revendication 1, dans lequel les pixels (P) et les modules de pilotage (SR_A, SR_B) sont réalisés sur un même substrat (14) à partir de transistors en couche mince de type N uniquement ou de type P uniquement.

3. Procédé d'utilisation d'un détecteur matriciel selon l'une des revendications précédentes, dans lequel des modules de pilotage (16) appartenant à des groupes distincts (A, B) et raccordés à des conducteurs de ligne (L) consécutifs peuvent recevoir des signaux de commande simultanés de façon à piloter les lignes consécutives simultanément ou des signaux de commande alternés de façon à piloter les lignes consécutives de façon séparées.

## Patentansprüche

1. Matrixdetektor, Folgendes umfassend:
- einen Satz (10) von Pixeln (P), die auf einen physikalischen Effekt ansprechen und in einer Matrix aus Pixelzeilen und -spalten organisiert sind, wobei jedes Pixel (P) ein vom physikalischen Effekt abhängiges Signal erzeugt, wobei die Pixelzeilen physikalisch geordnet sind,
Zeilenleiter (L), welche es jeweils ermöglichen, die Pixel (P) einer Zeile anzusteuern,
- Ansteuerungsmodule (SR_A, SR_B), die jeweils einem Zeilenleiter (L) zugeordnet sind, wobei die Ansteuerungsmodule Auswahlsignale (Out_A, Out_B; Gateline) jeweils an einen der Zeilenleiter (L) abgeben, wobei die Ansteuerungsmodule gemäß der Reihenfolge der Pixelzeilen in mehrere verschachtelte Gruppen unterteilt sind,
wobei die Ansteuerungsmodule (SR_A, SR_B) jeder Gruppe (A, B) in der physikalischen Reihenfolge der den betreffenden Gruppen von Ansteuerungsmodulen zugeordneten Zeilen miteinander verkettet sind, wobei die Verkettung jeder der Gruppen von Ansteuerungsmodulen unabhängig von der Verkettung der einen oder mehreren anderen Gruppen von Ansteuerungsmodulen ist,
- ein Modul (30) zur Erzeugung mehrerer Token (INA, INB), die jeweils an einen Eingang (In_A(N), In_B(N)) eines ersten der Ansteuerungsmodule (SR_A(N)) jeder Gruppe (A, B) von Ansteuerungsmodulen abgegeben werden, wobei in jeder der Gruppen von Ansteuerungsmodulen ein Ausgang (Out_A(n), Out_B(n)) jedes Moduls mit einem Eingang (In_A(n+1), In_B(n+1)) des Moduls von übergeordnetem Rang verbunden ist, wobei die Ansteuerungsmodule in jeder ihrer Gruppen (A, B) in der Reihenfolge der Pixelzeilen angeordnet sind, an deren Leiter das betreffende Ansteuerungsmodul das Auswahlsignal abgibt, wobei die Token (INA, INB) gleichzeitig ausgegeben werden können, was ein gruppenweises Auslesen von Pixeln (P) ermöglicht, und abwechselnd ausgegeben werden können, was ein individuelles Auslesen der Pixel (P) ermöglicht.

2. Matrixdetektor nach Anspruch 1, wobei die Pixel (P) und die Ansteuermodule (SR_A, SR_B) auf demselben Substrat (14) aus ausschließlich m-Typ- oder ausschließlich p-Typ-Dünnschichttransistoren hergestellt sind.

3. Verfahren zur Verwendung eines Matrixdetektors nach einem der vorhergehenden Ansprüche, wobei Ansteuerungsmodule (16), die zu unterschiedlichen Gruppen (A, B) gehören und mit aufeinanderfolgenden Zeilenleitern (L) verbunden sind, gleichzeitige Steuersignale, um die aufeinanderfolgenden Zeilen gleichzeitig anzusteuern, oder abwechselnde Steuersignale empfangen können, um die aufeinanderfolgenden Zeilen getrennt anzusteuern.

## Claims

1. A matrix-array detector comprising:
- an array (10) of pixels (P) that are sensitive to a physical effect and organised in a matrix in rows and columns of pixels, each pixel (P) generating a signal that is a function of the physical effect, the rows of pixels being physically ordered;
- row conductors (L), each allowing the pixels (P) of one row to be driven;
- driver modules (SR_A, SR_B), each associated with a row conductor (L), the driver modules each delivering selection signals (Out_A, Out_B; Gateline) to one of the row conductors (L), the driver modules being divided into several interleaved groups according to the order of the rows of pixels,
wherein the driver modules (SR_A, SR_B) of each group (A, B) are chained together in the physical order of the rows associated with the driver module groups in question, the chaining of each driver module group being independent of the chaining of the one or more other driver module groups,
- a generation module (30) for generating several tokens (INA, INB), each delivered to an input (In_A(N), In_B(N)) of a first of the driver modules (SR_A(N)) of each group (A, B) of driver modules, in each of the driver module groups, an output (Out_A(n), Out_B(n)) of each module being connected to an input (In_A(n+1), In_B(n+1)) of the module of higher rank, the driver modules being ordered in each of their groups (A, B) in the order of the rows of pixels to the conductor of which the driver module in question delivers the selection signal, it being possible for the tokens (INA, INB) to be emitted simultaneously, enabling pixels (P) to be read in groups, and it being possible for them to be emitted alternately, enabling the pixels (P) to be read individually.

2. The matrix-array detector according to claim 1, wherein the pixels (P) and the driver modules (SR_A, SR_B) are produced on one and the same substrate (14) on the basis of only n-type or of only p-type thin-film transistors.

3. A method for using a matrix-array detector according to one of the preceding claims, wherein the driver modules (16) belonging to separate groups (A, B) and connected to consecutive row conductors (L) can receive simultaneous control signals so as to manage the consecutive rows simultaneously, or alternating control signals so as to manage the consecutive rows separately.
